# EUROPEAN PATENT SPECIFICATION

(11) **EP 3 436 857 B1**
(45) Date of publication and mention of the grant of the patent: **25.12.2024**
(21) Application number: 16897257.8
(22) Date of filing: 28.03.2016
(51) Int. Cl.: G02B 6/42

(54) **OPTICAL FIBER CONNECTION ON PACKAGE EDGE**
FASEROPTISCHE VERBINDUNG AUF EINEM VERKAPSELUNGSRAND
CONNEXION DE FIBRES OPTIQUES SUR UN BORD D'EMBALLAGE

(43) Date of publication of application: 06.02.2019
(73) Proprietor: Intel Corporation, Santa Clara, CA 95054 (US)
(72) Inventor: ALBERS, Sven, 93049 Regensburg / BY (DE); DITTES, Marc, 93059 Regensburg / BY (DE); WOLTER, Andreas, 93051 Regensburg / BY (DE); REINGRUBER, Klaus, 84085 Langquaid / BY (DE); SEIDEMANN, Georg, 84036 Landshut / BY (DE); GEISSLER, Christian, 93356 Teugn / BY (DE); WAGNER, Thomas, 91189 Regelsbach (DE); PATTEN, Richard, 84085 Langquaid / BY (DE)
(74) Representative: 2SPL Patentanwälte PartG mbB
(86) International application number: PCT/US2016/024400
(87) International publication number: WO 2017/171696

(56) References cited:
- EP-B1- 1 542 046
- US-A1- 2005 008 302
- US-A1- 2005 018 977
- US-A1- 2005 141 584
- US-A1- 2006 039 658
- US-A1- 2009 074 352
- US-A1- 2011 182 546
- US-A1- 2013 241 050
- US-A1- 2013 343 711
- US-A1- 2015 050 019
- US-B1- 6 293 711

## Description

### TECHNICAL FIELD

This disclosure pertains to optical fiber connections on package edges, and more particularly, to mechanical and optical connections of optical fibers on package edges.

### BACKGROUND

Light is getting more and more interesting in the field of data processing. By transferring the data by light, losses (e.g., through wire attenuation) can be reduced. To use light for data transfer, electrical signals are translated into light signals and are inserted into an optical fiber (or fiber optics). On the receiver side, the light is transferred back into electrical signals. On both sides of the optical fiber, the fiber has to be fixed to a chip or package to achieve both mechanical coupling for stability and optical coupling to receive optical signals from the electrical circuitry and emit optical signals to the electrical circuitry.

US 2006/0039658 A1 relates to an optoelectronic conversion header, which includes a mounting substrate, a wiring substrate on the mounting substrate, and an integrated circuit on the wiring substrate. The mounting substrate may serve as a heat sink. The optoelectronic conversion header also includes a light emitter and an optical fiber inserted into a ferrule. The light emitter and the ferrule are shown to be located on the mounting substrate. A light absorbing resin covers the entire optoelectronic conversion header.

US 2011/0182546 A1 relates to a photoelectric conversion device. The device includes an electrical wiring formed on a circuit board. The device includes an optical fiber, and a molded portion covering an end portion and an end face of the optical fiber. The device further includes an optical device optically coupled to the optical fiber through the molded portion.

US 6293711 B1 discloses an optical transmission module including a substrate having a substantially trapezoidal first groove, an optical device mounted on the substrate for performing conversion between light and electricity, and a ferrule having a center hole and received in the first groove so as to be supported by beveled wall surfaces defining the first groove. An optical fiber is inserted and fixed in the center hole of the ferrule. The ferrule is cut away at a portion opposed to a bottom surface of the first groove.

US 2005/008302 A1 discloses an optic communications device including an optic communications module which includes a base, an optical element, a fiber optic piece, a ferrule, a transparent resin film, a wiring film, and a sealing member. The base plate and some other elements are divided into individual pieces each making up the optic communications module.

US 2005 / 141 584 A1 discloses an optical coupler including a semiconductor optical device, a lead frame on which the semiconductor optical device is disposed, a glass submount exemplifying a submount having light transmission and a lens provided on the glass submount. Further, a processing circuit covered with a molding portion is part of the optical coupler. The glass submount is bonded to the lead frame in such a way that the optical portion of the semiconductor optical device which is electrically connected to the glass submount faces an aperture.

### BRIEF DESCRIPTION OF THE DRAWINGS

FIG. 1 is a schematic diagram of an example optical fiber accommodating chip package in accordance with embodiments of the present disclosure.
FIG. 2 is a schematic diagram of another example optical fiber accommodating chip package in accordance with embodiments of the present disclosure.
FIG. 3 is a schematic diagram of an example optical fiber accommodating chip package and an example optical fiber connector in accordance with embodiments of the present disclosure.
FIGS. 4A-4F are schematic diagrams illustrating an example process flow for forming an optical fiber accommodating chip package in accordance with embodiments of the present disclosure.
FIGS. 5A-5B are schematic diagrams illustrating another example process flow for forming an optical fiber accommodating chip package in accordance with embodiments of the present disclosure.
FIGS. 6A-F are schematic diagrams illustrating an example process flow for forming an optical fiber accommodating chip package using flip-chip processing in accordance with embodiments of the present disclosure.
FIGS. 6G-H are schematic diagrams illustrating another example process flow for forming an optical fiber accommodating chip package using flip-chip processing in accordance with embodiments of the present disclosure.
FIG. 7 is a schematic block diagram of an example computing device that may be implemented in or include an optical fiber accommodating chip package in accordance with embodiments of the present disclosure.

### DETAILED DESCRIPTION

This disclosure describes a chip package that facilitates a self-aligning optical and mechanical edge connection to an optical fiber. The chip package described herein facilitates the connection of optical fibers directly with the chip package. The chip package described herein allows for shorter connection lengths and reduces the footprint of the system. Additionally, the integration ratio can be increased.

The chip package formation process can include the following features:
1. Implementation of a "optical window component" into the package;
2. Creation of a connector-retaining shape by, e.g., mold pressing or sawing; and
3. Exposure of an optical element (or window) during the chip package singulation process.

Other features are readily apparent by the following disclosure, accompanying figures, and the claims.

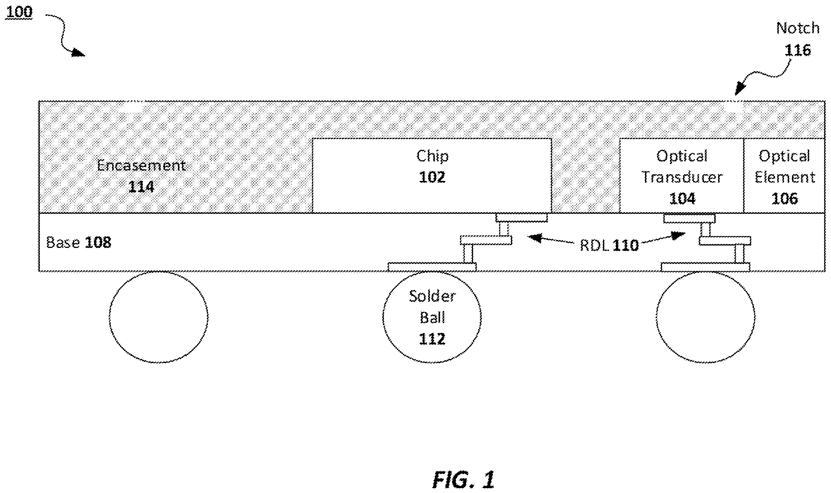

FIG. 1 is a schematic block diagram of an example optical fiber accommodating chip package 100 in accordance with embodiments of the present disclosure. Chip package 100 includes a chip 102 adjacent to and electrically coupled to an optical transducer 104. Optical transducer 104 can receive electrical signals from the chip 102 and convert the electrical signals into optical signals. The optical transducer 104 can emit the optical signals through the optical element 106. Optical element 106 can include any type of fiber optic compatible material (e.g., can transmit optical signals to and from an optical fiber), such as glass, optical-grade polymer, or other material. The chip package 100 includes a base 108 upon which the chip 102, the optical transducer 104, and the optical element 106 reside. The base 108 can include a dielectric material that can be processed to include a redistribution layer (RDL) 110. The RDL 110 can provide electrical interconnectivity between integrated circuit elements, and can facilitate access to integrated circuit elements through contact points, such as solder balls 112, contact pads, or other electrical contacts.

The chip package 100 also includes an encasement 114. Encasement 114 can include a mold compound, such as that used in embedded Wafer Level Ball Grid Array (eWLB) processing or other fan-out WLB processing techniques and flip-chip, or any other process that uses a mold cap. (EG filled epoxy-based materials) The mold compound used during formation of the encasement 114 can be a solid molding compound or a liquid molding compound. Examples of a mold compound include an EG-filled epoxy-based material.

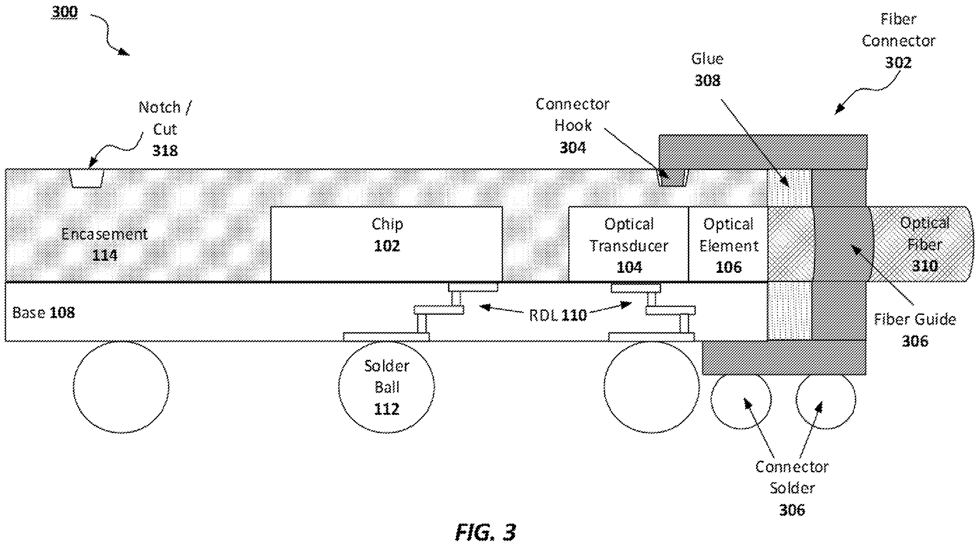

The encasement 114 includes a notch 116. The notch 116 can be formed on the top surface of the encasement 114 at a location proximate the optical transducer 104. For example, the notch 116 can be formed on the top surface of the encasement 114 above the optical transducer 104 and near the edge of the chip package 100. The notch 116 can be formed via mold pressing. The notch 116 can have a predetermined shape and size, and can be positioned to facilitate self-alignment of the optical connector component (shown in FIG. 3). For example, the notch 116 can be formed based on the shape and size of the corresponding optical fiber connector.

The optical element 106 resides proximate the edge of the chip package 100. The optical element 106 held in place by the encasement 114 or sandwiched between the encasement 114 and the base 108. A side of the optical element is flush (or substantially flush) with the edge of the chip package 100 and is, according to the invention, flush with the edge of the encasement 114. The side of the optical element 106 that is flush with the edge of the chip package 100 is exposed at the edge of the chip package 102 to transmit (i.e., optically transmit) optical signals to and from an optical fiber.

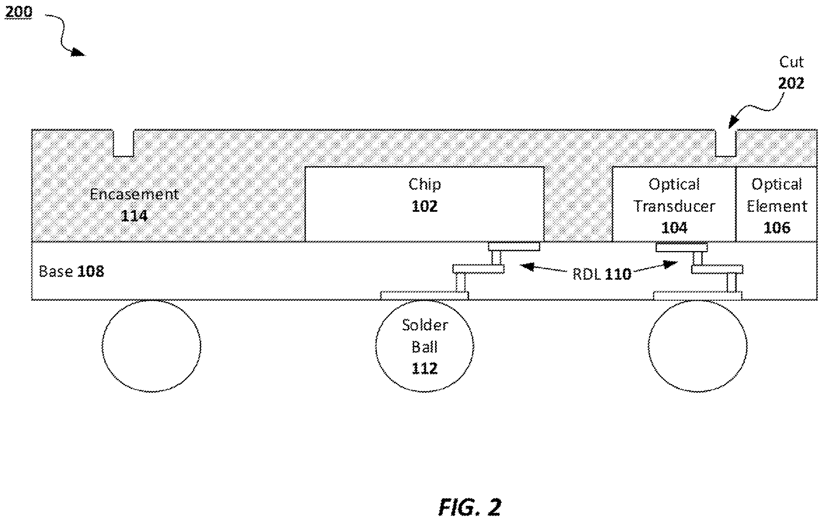

FIG. 2 is a schematic block diagram of another example optical fiber accommodating chip package 200 in accordance with embodiments of the present disclosure. Chip package 200 is similar to that of chip package 100 and includes similar features as shown in FIG. 2. Chip package 200, however, includes a cut 202 instead of a notch. Cut 202 can be formed by a saw or other cutting device. In some embodiments, the cut 202 can traverse along the entire chip package 200. In some embodiments, the cut 202 can be formed without cutting through the entire encasement 114, but rather, can be formed at a discrete location above the optical transducer 104 and/or above the optical element 106, depending on the shape and size of the optical fiber connector. The cut 202 can be formed at a top side of the encasement 114 proximate the optical transducer 104. The shape of the cut 202 can be predetermined to accommodate the optical fiber connector, shown in FIG. 3.

FIG. 3 is a schematic block diagram of an example optical fiber accommodating chip package and an example optical fiber connector in accordance with embodiments of the present disclosure. In FIG. 3, an optical fiber connector 302 is attached to the chip package 300. The optical fiber connector 302 is shaped to contact the top of the encasement 114 and the bottom of the chip package 300 (e.g., by contacting the base 108). The optical fiber connector 302 can also be physically biased to form a clamp to apply a clamping force on the chip package 300.

The optical fiber connector 302 can include a fiber guide 306. Fiber guide 306 can be configured to receive an optical fiber 310. The fiber guide 306 can provide structure support and strain relief for the optical fiber 310. The fiber guide 306 can hold the optical fiber 310 in place, and when the optical fiber connector 302 is connected to the chip package 300, the fiber guide 306 can hold the optical fiber 310 in place and in contact with the optical element 106, so that optical signals can be transmitted from the optical fiber 310 to the optical element 106, and optical signals can be transmitted from the optical element 106 to the optical fiber 310.

In some embodiments, a glue 308 can be used to add further structural support to the connection between the optical fiber connector 302 and the chip package 300. The glue 308 can be an optically transparent glue. The glue 308 can bind the optical fiber connector 302 to the encasement 114 and other parts of the chip package 300 as needed.

In some embodiments, the optical fiber connector 302 includes a connector hook 304. Connector hook 304 can fit into a notch / cut 318. In FIG. 3, the notch / cut 318 represents either the notch 116 from FIG. 1 or the cut 202 from FIG. 2. Either the notch or the cut can be used, depending on the design of the connector hook 304. In some embodiments, no notch or cut is used, and the optical fiber connector 302 can clamp onto the chip package 300. The connector hook 304 can be structured to match the notch / cut 318. Or, the notch / cut 318 can be formed to match the shape of the connector hook 304.

When connecting the optical fiber connector 302, the optical fiber connector 302 can slide over the encasement 114, and the connector hook 304 can connect into the notch / cut 318. The connection between the connector hook 304 and the notch / cut 318 can create a mechanical stop, preventing the optical fiber connector 302 from moving towards or away from the chip package 300. When a notch is used, the connection between the notch and the connector hook 304 may also prevent the optical fiber connector 302 from moving side-to-side, relative the chip package.

The connector hook 304 and the notch / cut 318 also facilitate self-alignment of the optical fiber connector 302 (and the optical fiber 310) with the chip package 300. By creating the notch / cut 318 in a predetermined position proximate the optical transducer 104 and/or the optical element 106, the notch / cut 318 acts as a guide and hard stop for receiving the connector hook 304.

In some embodiments, solder balls 306 are used to add further mechanical fixation between the optical fiber connector 302 and the base 108.

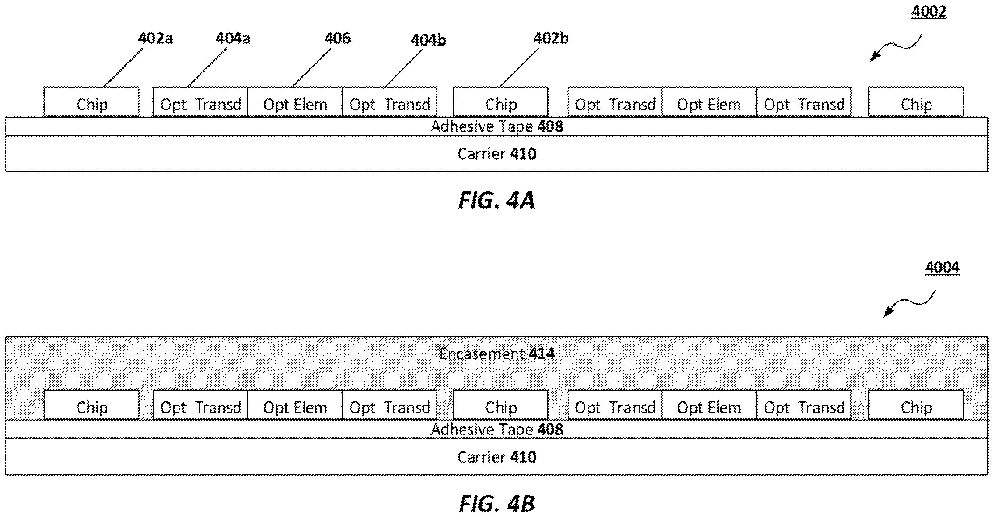

FIGS. 4A-4F are schematic block diagrams illustrating an example process flow for forming an optical fiber accommodating chip package in accordance with embodiments of the present disclosure. In general, the process flow can include an embedded Wafer Level Ball Grid Array (eWI,B) process flow or other type of process flow that can include a separation (e.g., saw separation) and/or a mold pressing process.

As illustrated in FIG. 4A, the chips 402a-b, optical transducers 404a-b, and optical elements 406 are placed on a carrier 410 using an adhesive tape 408. The chips 402a-b can be a storage or memory chip, processor, or other type of integrated circuit (4002).

In some embodiments, the optical transducers 404a is structured such that each optical element 406 is adjacent to and in optical communication with an optical transducers 404a. In some embodiments, the optical transducers 404a-b are structured such that each optical element 406 is adjacent to and in optical communication with an optical transducers 404a-b (i.e., one optical transducer 404a on one side of the optical element 406 and one optical transducer 404b on the other side of the optical element 406).

The arrangement of the chips 402a-b and the optical transducers 404a-b and the optical element 406 can be as follows. A chip 402a can reside adjacent to an optical transducer 404a. The optical transducer 404a can reside adjacent to the optical element 406, such that the optical transducer 404a is between the chip 402a and the optical element 406. The chip 402a and the optical transducer 404a can be electrical coupled through a redistribution layer, discussed later. A second optical transducer 404b can reside adjacent to the optical element 406, such that the optical element 406 is between the optical transducer 404a and the optical transducer 404b. A chip 402b can reside adjacent to the optical transducer 404b, such that the optical transducer 404b is between the optical element 406 and the chip 402b. The chip 402b and the optical transducer 404b can be electrical coupled through a redistribution layer, discussed later.

A predetermined number of chips, optical transducers, and optical elements can be placed on the carrier 410 in the above described orientation, depending on the size of the carrier.

As illustrated in FIG. 4B, an encasement 414 (also referred to as a moldcap 414) is formed (4004). The encasement 414 can be formed using a eWLB molding process, or a similar process. The encasement 414 covers the chips, optical transducers, and optical elements. In some embodiments, the encasement 414 can hold the chips, optical transducers, and optical elements in place. The encasement 414 can be a mold compound, similar to that used in eWLB processing techniques. A liquid mold compound can be dispersed over the chips, the optical transducers, and the optical elements and then solidified using known techniques. A solid mold compound can be applied using compression molding or other techniques known in the art.

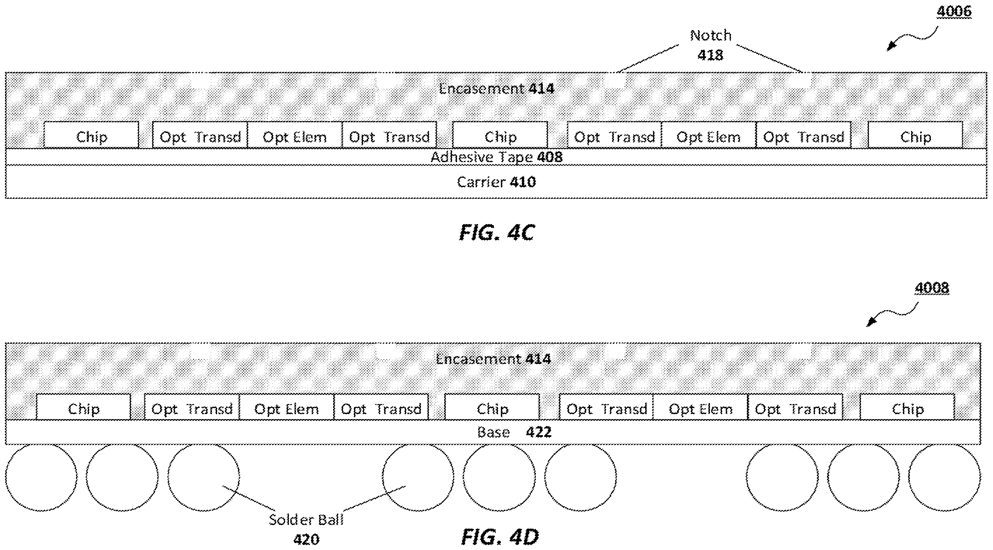

As illustrated in FIG. 4C, at least one notch 418 is formed in the encasement 414 (4006). Notches 418 can be formed by pressing a toothed structure into the encasement. The toothed structure can be part of the mold case used when forming the encasement 414, resulting in a notch in the top of the encasement at predetermined positions.

As illustrated in FIG. 4D, the encasement 414 and the chips and optical transducers and optical elements can be removed from the carrier 410 (4008). Also shown in FIG. 4D, the encasement and the chips and optical transducers and optical elements can reside on a base 422 that is fabricated through semiconductor or other dielectric processing techniques. The base 422 can be dielectric material that includes a redistribution layer. The redistribution layer can be formed through patterned metal layer deposition or other similar techniques. The base 422 can include the redistribution layer shown in FIGS. 1-3. In some embodiments, solder balls 420 can be used to physically connect the chips and optical transducers to the base 422. The solder balls can also provide electrical access to various interfaces on the chip and other electronics on the chip package.

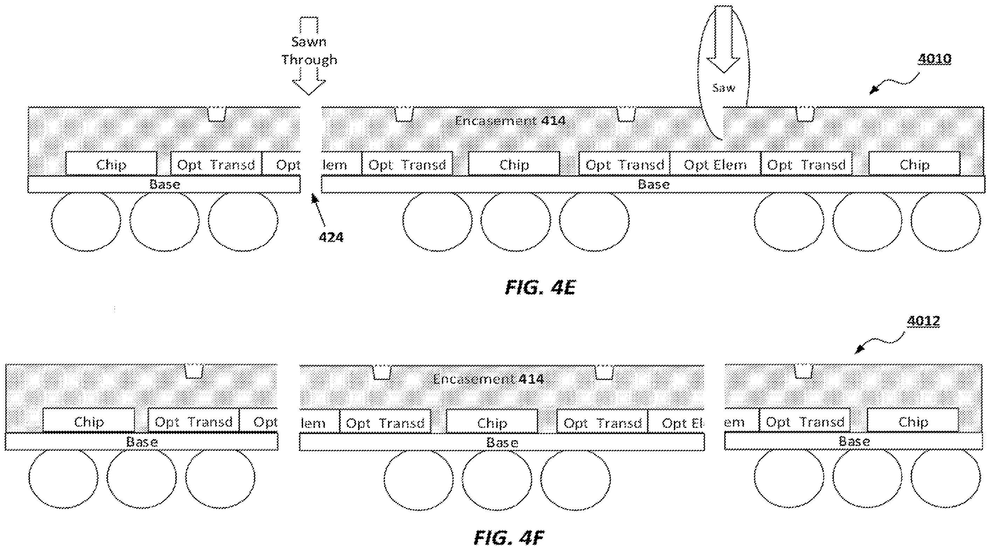

As illustrated in FIG. 4E, the chip package can undergo singulation to isolate individual chip packages (4010). Singulation can be similar to singulation techniques used in eWLB processing. For example, the chip package can be sawed through to singulate the chip package.

The chip package can be sawed through the center of each optical element, e.g., at a location 424. This sawing location can result in the optical element being at an edge of each resulting singulated chip package. Further, the optical element, after singulation, is exposed to the air. Sawing is performed in such a manner that the optical element is cleanly cut. In some embodiments, the optical element can be polished after singulation.

As illustrated in FIG. 4F, the chip package can be sawed for singulation through optical elements for all of the optical elements on the original chip package (4012).

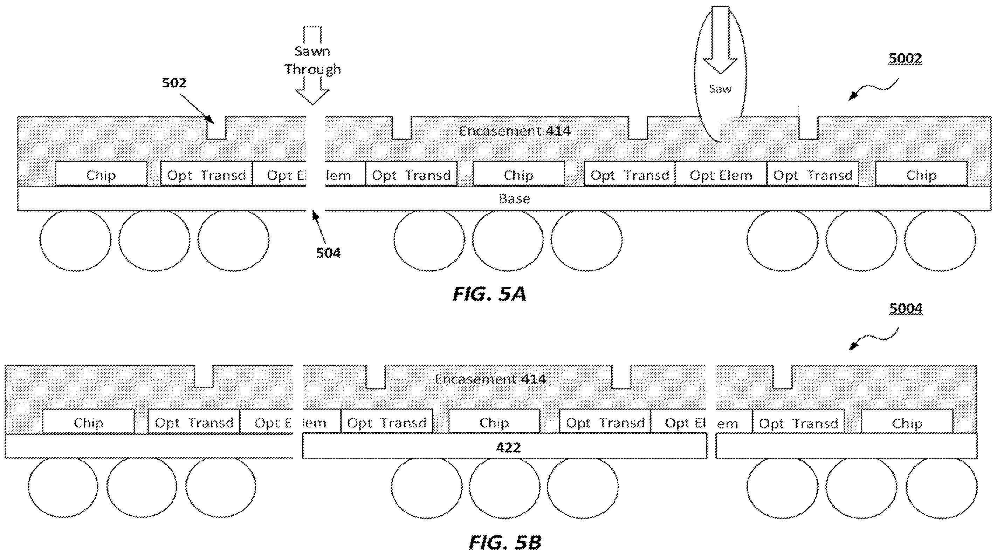

FIGS. 5A-5B are schematic block diagrams illustrating another example process flow for forming an optical fiber accommodating chip package in accordance with embodiments of the present disclosure. FIG. 5A starts after the processes shown in FIGS. 4A-B. As illustrated in FIG. 5A, the encasement 414 and the chip and optical transducers and optical elements have been lifted off of the carrier. In FIG. 5A, the chip package includes a base and includes solder balls to add physical stability between the chip and optical transducer and the base.

As illustrated in FIG. 5A, the chip package undergoes singulation by sawing through the encasement and the base at a location 504 through the optical element (5002). In the same sawing process, the cuts 502 are made in the encasement. The cuts 502 will act as the receiver for the optical fiber connector. By using the saw to form the cuts 502, the number of tools and steps can be reduced.

As illustrated in FIG. 5B, the sawing can result in both the cuts 502 in the encasement and the singulation of the chip package (5004).

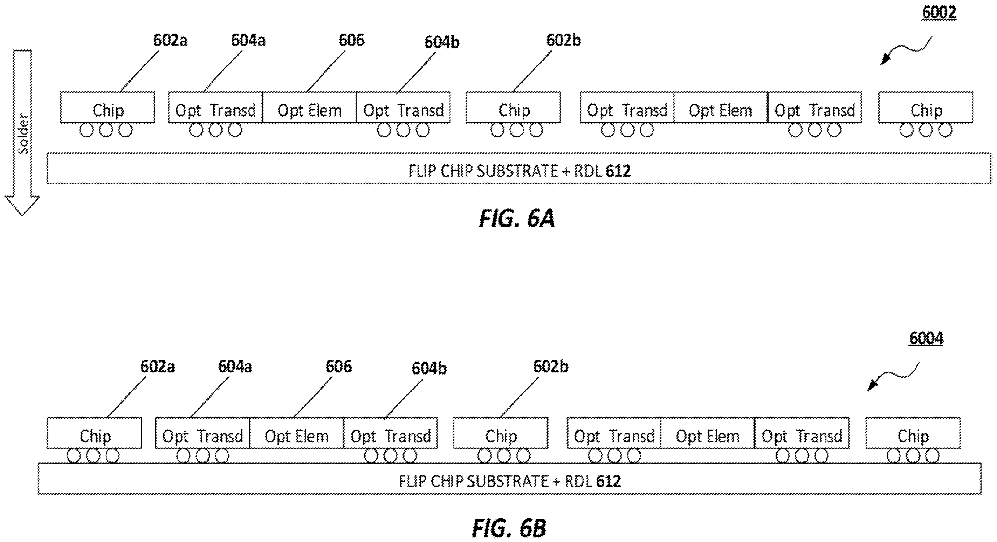

FIGS. 6A-F are schematic diagrams illustrating an example process flow for forming an optical fiber accommodating chip package using flip-chip processing in accordance with embodiments of the present disclosure.

As illustrated in FIG. 6A, a set of chips 602a and 602b can be soldered to a prefabricated flip chip substrate that includes a redistribution layer (flip chip substrate + RDL) 612 (6002). The resulting structure is illustrated in FIG. 6B (6004). The RDL layer can be formed processing the flip chip substrate and designed to accommodate the chip pins and the optical transducer pins. The RDL can also provide landing pads for solder balls.

In some embodiments, the optical transducers 604a is structured such that each optical element 406 is adjacent to and in optical communication with an optical transducers 604a. In some embodiments, the optical transducers 604a-b are structured such that each optical element 606 is adjacent to and in optical communication with an optical transducers 604a-b (i.e., one optical transducer 604a on one side of the optical element 606 and one optical transducer 604b on the other side of the optical element 606).

The arrangement of the chips 602a-b and the optical transducers 604a-b and the optical element 606 can be as follows. A chip 602a can reside adjacent to an optical transducer 604a. The optical transducer 604a can reside adjacent to the optical element 606, such that the optical transducer 604a is between the chip 402a and the optical element 606. The chip 602a and the optical transducer 604a can be electrical coupled through a redistribution layer, discussed later. A second optical transducer 604b can reside adjacent to the optical element 606, such that the optical element 606 is between the optical transducer 604a and the optical transducer 604b. A chip 602b can reside adjacent to the optical transducer 604b, such that the optical transducer 604b is between the optical element 606 and the chip 602b. The chip 602b and the optical transducer 604b can be electrical coupled through a redistribution layer, discussed later.

A predetermined number of chips, optical transducers, and optical elements can be placed on the flip chip substrate + RDL 612 in the above described orientation, depending on the size of the substrate.

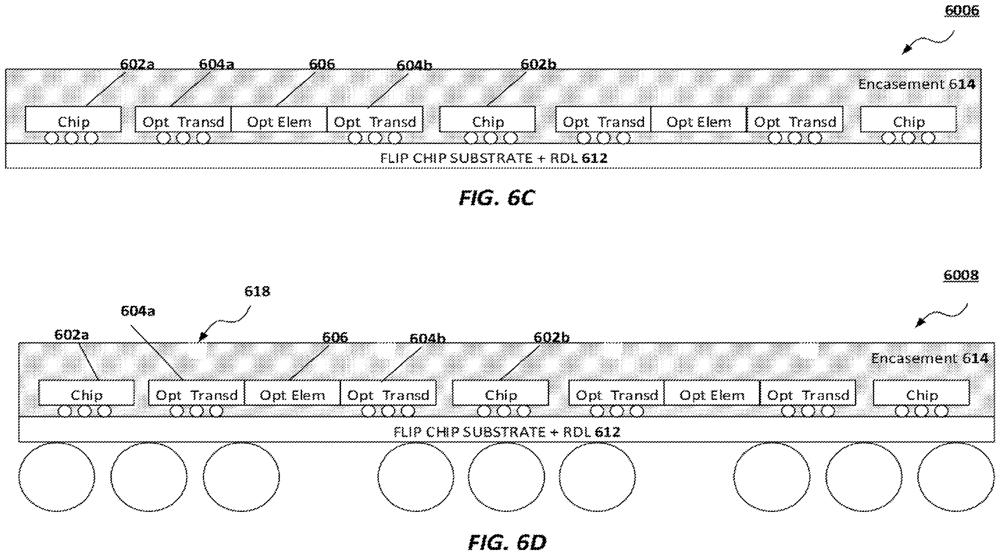

As illustrated in FIG. 6C, an encasement 614 (also referred to as a moldcap 614) is formed (6006). The encasement 614 can be formed using a eWLB molding process, or a similar process. The encasement 614 covers the chips, optical transducers, and optical elements. In some embodiments, the encasement 614 can hold the chips, optical transducers, and optical elements in place. The encasement 614 can be a mold compound, similar to that used in eWLB processing techniques. A liquid mold compound can be dispersed over the chips, the optical transducers, and the optical elements and then solidified using known techniques. A solid mold compound can be applied using compression molding or other techniques known in the art.

As illustrated in FIG. 6D, at least one notch 618 is formed in the encasement 614 (6008). Notches 618 can be formed by pressing a toothed structure into the encasement. The toothed structure can be part of the mold case used when forming the encasement 614, resulting in a notch in the top of the encasement at predetermined positions. In some embodiments, solder balls 620 can be used to physically connect the chips and optical transducers to the flip chip substrate + RDL 612. The solder balls can also provide electrical access to various interfaces on the chip and other electronics on the chip package.

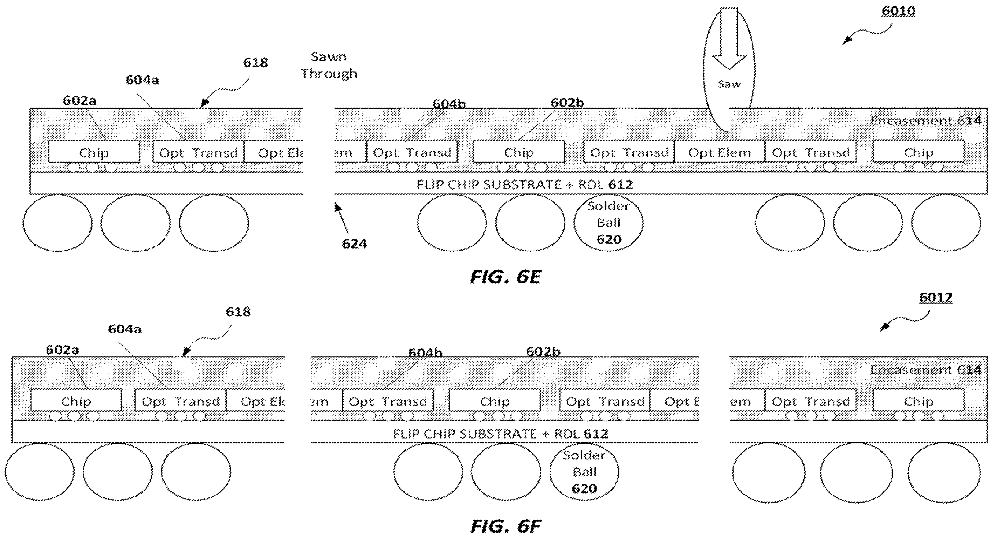

As illustrated in FIG. 6E, the encasement 614 and the chips and optical transducers and optical elements can be sawed to form singulated packages (6010). The chip package can undergo singulation to isolate individual chip packages. Singulation can be similar to singulation techniques used in eWLB processing. For example, the chip package can be sawed through to singulate the chip package.

The chip package can be sawed through the center of each optical element, e.g., at a location 624. This sawing location can result in the optical element being at an edge of each resulting singulated chip package. Further, the optical element, after singulation, is exposed to the air. Sawing is performed in such a manner that the optical element is cleanly cut. In some embodiments, the optical element can be polished after singulation.

As illustrated in FIG. 6F, the chip package can be sawed for singulation through optical elements for all of the optical elements on the original chip package (6012).

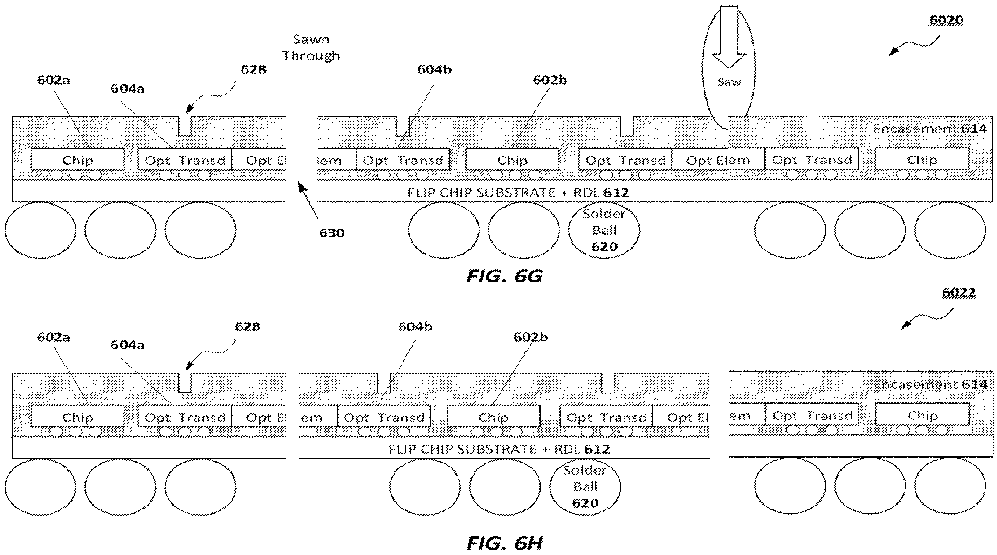

FIGS. 6G-H are schematic diagrams illustrating another example process flow for forming an optical fiber accommodating chip package using flip-chip processing in accordance with embodiments of the present disclosure. As illustrated in FIG. 6G, the chip package undergoes singulation by sawing through the encasement and the flip-chip substrate + RDL 612 at a location 630 through the optical element (6020). In the same sawing process, the cuts 628 are made in the encasement. The cuts 628 will act as the receiver for the optical fiber connector. By using the saw to form the cuts 628, the number of tools and steps can be reduced.

As illustrated in FIG. 6H, the sawing can result in both the cuts 628 in the encasement and the singulation of the chip package (6022).

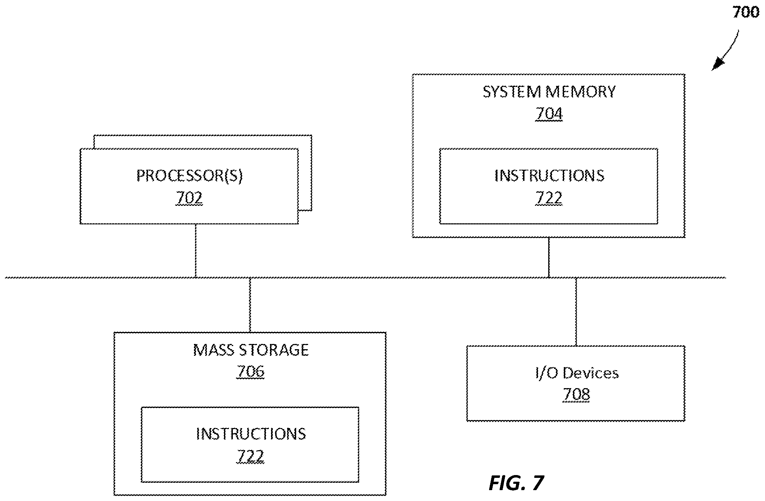

FIG. 7 is a block diagram of an example computing device 700 that may include or be included in the flexible IC package 100 (e.g., as a wearable IC device). As shown, the computing device 700 may include one or more processors 702 (e.g., one or more processor cores implemented on one or more components) and a system memory 704 (implemented on one or more components). As used herein, the term "processor" or "processing device" may refer to any device or portion of a device that processes electronic data from registers and/or memory to transform that electronic data into other electronic data that may be stored in registers and/or memory. The processor(s) 702 may include one or more microprocessors, graphics processors, digital signal processors, crypto processors, or other suitable devices. More generally, the computing device 700 may include any suitable computational circuitry, such as one or more Application Specific Integrated Circuits (ASICs).

The computing device 700 may include one or more mass storage devices 706 (such as flash memory devices or any other mass storage device suitable for inclusion in a flexible IC package). The system memory 704 and the mass storage device 706 may include any suitable storage devices, such as volatile memory (e.g., dynamic random access memory (DRAM)), nonvolatile memory (e.g., read-only memory (ROM)), and flash memory. The computing device 700 may include one or more I/O devices 708 (such as display, user input device, network interface cards, modems, and so forth, suitable for inclusion in a flexible IC device). The elements may be coupled to each other via a system bus 712, which represents one or more buses.

Each of these elements may perform its conventional functions known in the art. In particular, the system memory 704 and the mass storage device 706 may be employed to store a working copy and a permanent copy of programming instructions 722.

The permanent copy of the programming instructions 722 may be placed into permanent mass storage devices 706 in the factory or through a communication device included in the I/O devices 708 (e.g., from a distribution server (not shown)). The constitution of elements 702-712 are known, and accordingly will not be further described.

Machine-accessible media (including non-transitory computer-readable storage media), methods, systems, and devices for performing the above-described techniques are illustrative examples of embodiments disclosed herein for thermal management of an IC device. For example, a computer-readable media (e.g., the system memory 704 and/or the mass storage device 706) may have stored thereon instructions (e.g., the instructions 722) such that, when the instructions are executed by one or more of the processors 702.

As noted above, although the thermal management systems and techniques disclosed herein may be particularly advantageous when used to thermally manage flexible IC packages, these systems and techniques may also be implemented to improve thermal management of conventional, rigid IC packages. Thus, any of the embodiments disclosed herein and described as applicable in a flexible IC package may also apply in a conventional, rigid IC package setting. Such a rigid IC package may include, for example, a rigid substrate material and/or a rigid overmold material.

Additionally, although the thermal management systems and techniques disclosed herein may be particularly advantageous when used to thermally manage components (or "component sections," as discussed above), these systems and techniques may be used to thermally manage any devices included in an IC package, such as a resistor, capacitor, transistor, inductor, radio, memory, processor, laser, light-emitting diode (LED), sensor, a memory gate, combinational or state logic, or other digital or analog component. A device thermally managed by the thermal management systems and techniques disclosed herein may be a packaged component (e.g., a surface mount, flip chip, ball grid array, land grid array, bumpless buildup layer, or other package) or an unpackaged component.

The relative sizes of features shown in the figures are not drawn to scale.

## Claims

1. A method comprising:
providing (4002) an optical transducer (104, 404) and an optical element (106, 406) adjacent to the optical transducer (104, 404) on a carrier (410);
encasing (4004) the optical transducer (104, 404) and the optical element (106, 406) with an encasement (114, 414);
forming (4010) a connector receiver (116, 202, 418, 502) in the encasement (114, 414) at a top side of the encasement (114, 414) at a location proximate to the optical transducer (104, 404), wherein the connector receiver (116, 202, 418, 502) is for receiving a tooth (304) of an optical fiber connector (302); and
cutting (4010) the encasement (114, 414) and the optical element (106, 406) to expose a side of the optical element (106, 406), wherein the side of the optical element (106, 406) is flush with the edge of the encasement (114, 414).

2. The method of claim 1, further comprising providing (4002) an integrated circuit (102) proximate the optical transducer (104, 404), the optical transducer (104, 404) between the optical element (106, 406) and the integrated circuit (102).

3. The method of claim 1 or 2, wherein the optical transducer (104, 404) is a first optical transducer (404a), and wherein the first optical transducer (404a) resides on a first side of the optical element (106, 406), the method further comprising:
providing a second optical transducer (404b) residing on a second side of the optical element (106, 406), opposite the first side of the optical element (106, 406); and
wherein cutting the encasement (114, 414) and the optical element (106, 406) comprises:
cutting through the optical element (106, 406) to divide the optical element (106, 406) into two segments, a first segment of the optical element (106, 406) adjacent to the first optical transducer (404a) and a second segment of the optical element adjacent to the second optical transducer (404b).

4. The method of any of claims 1 or 3, further a comprising forming (4008) a base (108, 422) on an exposed side of the optical transducer (104, 404) and forming a redistribution layer (110) in the base (108, 422).

5. The method of claim 1 or 3 or 4, further comprising forming (4008) one or more solder balls (112, 420) electrically connected to the optical transducer (104, 404) through a redistribution layer (110) in the base (108, 422).

6. The method of claim 1, wherein providing an optical transducer (104, 404) and an optical element (106, 406) adjacent to the optical transducer (104, 404) on a carrier (410) comprises soldering the optical transducer (104, 404) to a prefabricated substrate, the prefabricated substrate comprising an integrated redistribution layer (RDL) (110), wherein soldering the optical transducer (104, 404) to the prefabricated substrate comprises soldering the optical transducer (104, 404) to a contact pad of the RDL (110).

7. An apparatus (100, 300) comprising:
a base (108, 422) comprising a redistribution layer (110) for providing electrical interconnectivity;
an optical transducer circuit element (104, 404) on the base electrically connected to the redistribution layer (110);
an optical element (106, 406) adjacent to the optical transducer circuit element (104, 404) and at an edge of the base (108, 422), wherein the optical transducer circuit element (104, 404) is configured to convert electrical signals into optical signals, and to emit the optical signals through the optical element (106, 406);
an encasement (114, 414) encasing the optical transducer circuit element (104, 404) and a portion of the optical element (106, 406), wherein one side of the optical element (106, 406) is exposed at an edge of the encasement (114, 414) and at the edge of the base (108, 422), wherein the side of the optical element (106, 406) is flush with the edge of the encasement (114, 414), wherein a bottom side of the encasement (114, 414) is facing the base (108, 422);
a connector receiver (116, 202, 418, 502) formed on a top side opposite the bottom side of the encasement (114, 414) at a location in the encasement proximate the optical transducer (104, 404), wherein the connector receiver (116, 202, 418, 502) is for receiving a tooth (304) of an optical fiber connector (302).

8. The apparatus of claim 7, further comprising an integrated circuit (102) residing on the base (108, 422) and electrically connected to the redistribution layer (110), the optical transducer circuit element (104, 404) residing between the optical element (106, 406) and the integrated circuit (102).

9. A computing system (700) comprising the apparatus of claim 8, and further comprising an optical fiber connector (302) connected to the edge of the encasement (114, 414), the optical fiber connector (302) comprising a clamp and a tooth (304) on an inner portion of the clamp, the tooth (304) received in the connector receiver (116, 202, 418, 502).

10. The computing system of claim 9, wherein the optical fiber connector (302) comprises an optical fiber (310) in contact with the exposed portion of the optical element (106, 406), the optical fiber connector (302) securing the optical fiber in place (310).

11. The computing system of claim 9 or 10, further comprising a transparent glue (308) securing the optical fiber connector (302) against the edge of the encasement (114, 414).

## Patentansprüche

1. Verfahren, umfassend:
Bereitstellen (4002) eines optischen Wandlers (104, 404) und eines optischen Elements (106, 406) angrenzend an den optischen Wandler (104, 404) auf einem Träger (410);
Umhüllen (4004) des optischen Wandlers (104, 404) und des optischen Elements (106, 406) mit einer Umhüllung (114, 414);
Bilden (4010) einer Verbinderaufnahme (116, 202, 418, 502) in der Umhüllung (114, 414) auf einer Oberseite der Umhüllung (114, 414) an einer Stelle in der Nähe des optischen Wandlers (104, 404), wobei die Verbinderaufnahme (116, 202, 418, 502) zum Aufnehmen eines Zahns (304) eines faseroptischen Verbinders (302) dient; und
Schneiden (4010) der Umhüllung (114, 414) und des optischen Elements (106, 406), um eine Seite des optischen Elements (106, 406) freizulegen, wobei die Seite des optischen Elements (106, 406) bündig mit dem Rand der Umhüllung (114, 414) ist.

2. Verfahren nach Anspruch 1, ferner umfassend ein Bereitstellen (4002) einer integrierten Schaltung (102) in der Nähe des optischen Wandlers (104, 404), wobei der optische Wandler (104, 404) zwischen dem optischen Element (106, 406) und der integrierten Schaltung (102) ist.

3. Verfahren nach Anspruch 1 oder 2, wobei der optische Wandler (104, 404) ein erster optischer Wandler (404a) ist und wobei sich der erste optische Wandler (404a) auf einer ersten Seite des optischen Elements (106, 406) befindet, das Verfahren ferner umfassend:
Bereitstellen eines zweiten optischen Wandlers (404b), der sich auf einer zweiten Seite des optischen Elements (106, 406) gegenüber der ersten Seite des optischen Elements (106, 406) befindet; und
wobei das Schneiden der Umhüllung (114, 414) und des optischen Elements (106, 406) umfasst:
Schneiden durch das optische Element (106, 406), um das optische Element (106, 406) in zwei Segmente zu teilen, ein erstes Segment des optischen Elements (106, 406) angrenzend an den ersten optischen Wandler (404a) und ein zweites Segment des optischen Elements angrenzend an den zweiten optischen Wandler (404b).

4. Verfahren nach einem der Ansprüche 1 oder 3, ferner umfassend ein Bilden (4008) einer Basis (108, 422) auf einer freiliegenden Seite des optischen Wandlers (104, 404) und Bilden einer Umverteilungsschicht (110) in der Basis (108, 422).

5. Verfahren nach Anspruch 1 oder 3 oder 4, ferner umfassend ein Bilden (4008) einer oder mehrerer Lötkugel(n) (112, 420), die elektrisch mit dem optischen Wandler (104, 404) durch eine Umverteilungsschicht (110) in der Basis (108, 422) verbunden ist/sind.

6. Verfahren nach Anspruch 1, wobei das Bereitstellen eines optischen Wandlers (104, 404) und eines optischen Elements (106, 406) angrenzend an den optischen Wandler (104, 404) auf einem Träger (410) ein Löten des optischen Wandlers (104, 404) an ein vorgefertigtes Substrat umfasst, wobei das vorgefertigte Substrat eine integrierte Umverteilungsschicht (RDL) (110) umfasst, wobei das Löten des optischen Wandlers (104, 404) an das vorgefertigte Substrat ein Löten des optischen Wandlers (104, 404) an eine Kontaktstelle des RDL (110) umfasst.

7. Einrichtung (100, 300), umfassend:
eine Basis (108, 422), die eine Umverteilungsschicht (110) zum Bereitstellen elektrischer Interkonnektivität umfasst;
ein Schaltungselement eines optischen Wandlers (104, 404) auf der Basis, das elektrisch mit der Umverteilungsschicht (110) verbunden ist;
ein optisches Element (106, 406) angrenzend an das Schaltungselement eines optischen Wandlers (104, 404) und an einem Rand der Basis (108, 422), wobei das Schaltungselement eines optischen Wandlers (104, 404) dazu ausgelegt ist, elektrische Signale in optische Signale umzuwandeln und die optischen Signale durch das optische Element (106, 406) zu emittieren; eine Umhüllung (114, 414), die das optische Schaltungselement eines optischen Wandlers (104, 404) und einen Abschnitt des optischen Elements (106, 406) umhüllt, wobei eine Seite des optischen Elements (106, 406) an einem Rand der Umhüllung (114, 414) und am Rand der Basis (108, 422) freiliegt, wobei die Seite des optischen Elements (106, 406) bündig mit dem Rand der Umhüllung (114, 414) ist, wobei eine Unterseite der Umhüllung (114, 414) der Basis (108, 422) zugewandt ist; eine Verbinderaufnahme (116, 202, 418, 502), die auf einer Oberseite gegenüber der Unterseite der Umhüllung (114, 414) an einer Stelle in der Umhüllung in der Nähe des optischen Wandlers (104, 404) gebildet ist, wobei die Verbinderaufnahme (116, 202, 418, 502) zum Aufnehmen eines Zahns (304) eines faseroptischen Verbinders (302) dient.

8. Einrichtung nach Anspruch 7, ferner umfassend eine integrierte Schaltung (102), die sich auf der Basis (108, 422) befindet und elektrisch mit der Umverteilungsschicht (110) verbunden ist, wobei sich das Schaltungselement eines optischen Wandlers (104, 404) zwischen dem optischen Element (106, 406) und der integrierten Schaltung (102) befindet.

9. Rechensystem (700), umfassend die Einrichtung nach Anspruch 8 und ferner umfassend einen faseroptischen Verbinder (302), der mit dem Rand der Umhüllung (114, 414) verbunden ist, wobei der faseroptische Verbinder (302) eine Klemme und einen Zahn (304) an einem inneren Abschnitt der Klemme umfasst, wobei der Zahn (304) in der Verbinderaufnahme (116, 202, 418, 502) aufgenommen ist.

10. Rechensystem nach Anspruch 9, wobei der faseroptische Verbinder (302) eine optische Faser (310) in Kontakt mit dem freiliegenden Abschnitt des optischen Elements (106, 406) umfasst, wobei der faseroptische Verbinder (302) die optische Faser (310) in Position hält.

11. Rechensystem nach Anspruch 9 oder 10, ferner umfassend einen transparenten Klebstoff (308), der den faseroptischen Verbinder (302) am Rand der Umhüllung (114, 414) hält.

## Revendications

1. Procédé comprenant :
la fourniture (4002) d'un transducteur optique (104, 404) et d'un élément optique (106, 406) adjacent au transducteur optique (104, 404) sur un support (410) ;
l'enrobage (4004) du transducteur optique (104, 404) et de l'élément optique (106, 406) dans un enrobage (114, 414) ;
la formation (4010) d'un récepteur de connecteur (116, 202, 418, 502) dans l'enrobage (114, 414) sur un côté supérieur de l'enrobage (114, 414) à un emplacement proche du transducteur optique (104, 404), le récepteur de connecteur (116, 202, 418, 502) étant destiné à recevoir une dent (304) d'un connecteur de fibre optique (302) ; et
le découpage (4010) de l'enrobage (114, 414) et de l'élément optique (106, 406) pour exposer un côté de l'élément optique (106, 406), le côté de l'élément optique (106, 406) affleurant le bord de l'enrobage (114, 414) .

2. Procédé selon la revendication 1, comprenant en outre la fourniture (4002) d'un circuit intégré (102) à proximité du transducteur optique (104, 404), le transducteur optique (104, 404) étant situé entre l'élément optique (106, 406) et le circuit intégré (102).

3. Procédé selon la revendication 1 ou 2, dans lequel le transducteur optique (104, 404) est un premier transducteur optique (404a), et dans lequel le premier transducteur optique (404a) se trouve sur un premier côté de l'élément optique (106, 406), le procédé comprenant en outre :
la fourniture d'un deuxième transducteur optique (404b) se trouvant sur un deuxième côté de l'élément optique (106, 406), opposé au premier côté de l'élément optique (106, 406) ; et
dans lequel le découpage de l'enrobage (114, 414) et de l'élément optique (106, 406) comprend :
le découpage à travers l'élément optique (106, 406) pour subdiviser l'élément optique (106, 406) en deux segments, un premier segment de l'élément optique (106, 406) adjacent au premier transducteur optique (404a) et un second segment de l'élément optique adjacent au deuxième transducteur optique (404b).

4. Procédé selon l'une quelconque des revendications 1 ou 3, comprenant en outre la formation (4008) d'une base (108, 422) sur un côté exposé du transducteur optique (104, 404) et la formation d'une couche de redistribution (110) dans la base (108, 422).

5. Procédé selon la revendication 1 ou 3 ou 4, comprenant en outre la formation (4008) d'une ou plusieurs billes de soudure (112, 420) connectées électriquement au transducteur optique (104, 404) par l'intermédiaire d'une couche de redistribution (110) dans la base (108, 422).

6. Procédé selon la revendication 1, dans lequel la fourniture d'un transducteur optique (104, 404) et d'un élément optique (106, 406) adjacent au transducteur optique (104, 404) sur un support (410) comprend le soudage du transducteur optique (104, 404) sur un substrat préfabriqué, le substrat préfabriqué comprenant une couche de redistribution (RDL) intégrée (110), le soudage du transducteur optique (104, 404) sur le substrat préfabriqué comprenant le soudage du transducteur optique (104, 404) sur un plot de contact du RDL (110).

7. Appareil (100, 300), comprenant :
une base (108, 422) comprenant une couche de redistribution (110) pour fournir une interconnectivité électrique ;
un élément de circuit de transducteur optique (104, 404) sur la base électriquement connectée à la couche de redistribution (110) ;
un élément optique (106, 406) adjacent à l'élément de circuit de transducteur optique (104, 404) et au niveau d'un bord de la base (108, 422), l'élément de circuit de transducteur optique (104, 404) étant configuré pour convertir des signaux électriques en signaux optiques, et pour émettre les signaux optiques à travers l'élément optique (106, 406) ;
un enrobage (114, 414) enrobant l'élément de circuit de transducteur optique (104, 404) et une partie de l'élément optique (106, 406), un côté de l'élément optique (106, 406) étant exposé au niveau d'un bord de l'enrobage (114, 414) et au niveau du bord de la base (108, 422), le côté de l'élément optique (106, 406) affleurant le bord de l'enrobage (114, 414), un côté inférieur de l'enrobage (114, 414) étant dirigé vers la base (108, 422) ;
un récepteur de connecteur (116, 202, 418, 502) formé sur un côté supérieur opposé au côté inférieur de l'enrobage (114, 414) à un emplacement dans l'enrobage proche du transducteur optique (104, 404), le récepteur de connecteur (116, 202, 418, 502) étant destiné à recevoir une dent (304) d'un connecteur de fibre optique (302).

8. Appareil selon la revendication 7, comportant en outre un circuit intégré (102) se trouvant sur la base (108, 422) et connecté électriquement à la couche de redistribution (110), l'élément de circuit de transducteur optique (104, 404) se trouvant entre l'élément optique (106, 406) et le circuit intégré (102).

9. Système informatique (700) comprenant l'appareil selon la revendication 8, et comprenant en outre un connecteur de fibre optique (302) connecté au bord de l'enrobage (114, 414), le connecteur de fibre optique (302) comprenant une pince et une dent (304) sur une partie intérieure de la pince, la dent (304) étant reçue dans le récepteur de connecteur (116, 202, 418, 502).

10. Système informatique selon la revendication 9, dans lequel le connecteur de fibre optique (302) comprend une fibre optique (310) en contact avec la partie exposée de l'élément optique (106, 406), le connecteur de fibre optique (302) fixant la fibre optique (310) en place.

11. Système informatique selon la revendication 9 ou 10, comprenant en outre une colle transparente (308) fixant le connecteur de fibre optique (302) contre le bord de l'enrobage (114, 414).
